# EUROPEAN PATENT APPLICATION

(11) **EP 4 814 528 A1**
(43) Date of publication of application: **30.09.2026**
(21) Application number: 24911411.7
(22) Date of filing: 27.12.2024
(51) Int. Cl.: G01R 35/00

(54) **PROBE TIP DETECTION METHOD AND SYSTEM, ELECTRONIC DEVICE, AND STORAGE MEDIUM**

(30) Priority: 27.12.2023 CN 202311821913
(71) Applicant: Sidea Semiconductor Equipment (Shenzhen) Co., Ltd., Shenzhen, Guangdong 518172 (CN)
(72) Inventor: WU, Guiyang, Shenzhen, Guangdong 518172 (CN); LIU, Zimin, Shenzhen, Guangdong 518172 (CN); YANG, Yingjun, Shenzhen, Guangdong 518172 (CN)
(74) Representative: Arnason Faktor
(86) International application number: PCT/CN2024/143000
(87) International publication number: WO 2025/140490

(57) **Abstract**

Embodiments of the present application relate to the technical field of semiconductor testing, and provide a probe tip detection method and system, an electronic device, and a storage medium. The method comprises: acquiring a first image captured when probes under detection are inserted into electronic components, and box-selecting a probe inserted image of a target electronic component; aligning the probe inserted image with a reference template, wherein the reference template is obtained by box-selecting the target electronic component in a second image that is obtained when the probes under detection are not inserted; establishing grayscale matrices for the probe inserted image and the reference template, and determining a tip shape of each probe under detection on the basis of the grayscale matrices; determining from the first image multiple tip perpendicular lines in the direction of each probe under detection, detecting the multiple tip perpendicular lines line by line until a target grayscale point is detected, and using the position of the target grayscale point as a tip position; and on the basis of the tip shape and the tip position, obtaining a probe tip detection result. The present application can improve the accuracy of probe tip detection results and the efficiency of identification.

## Description

### TECHNICAL FIELD

The present disclosure relates to the technical field of semiconductor testing, and specifically to a probe tip detection method and system, an electronic device, and a storage medium.

### BACKGROUND

Probes are typically utilized during semiconductor chip testing. The sharp tip and miniature dimensions of a probe enable accurate and stable contact with electronic components on a chip surface for signal input and output.

However, such sharp tip and miniature dimensions make it difficult to visually detect probe anomalies, such as bending, misalignment, or contamination. Consequently, during semiconductor chip testing with a probe, a probe defect is usually identifiable only after a large batch of continuous test data exhibits anomalies. Furthermore, the shape and position of the probe tip still need to be identified visually, which can easily lead to inaccurate identification results and low identification efficiency.

### SUMMARY

A main objective of embodiments of the present disclosure is to provide a probe tip detection method and system, an electronic device, and a storage medium, which can identify the shape or position of probe tips without analyzing a large batch of test data, thereby improving the accuracy of identification results and the efficiency of identification.

To achieve the above objective, in accordance with a first aspect of the present disclosure, an embodiment provides a probe tip detection method, including: acquiring a first image captured when electronic components are probed by a probe under detection, and extracting a probing image of a target electronic component from the first image; aligning the probing image with a reference template, where the reference template is obtained by extracting the target electronic component in a second image, and the second image is captured when the target electronic component is not probed by the probe under detection; establishing a grayscale matrix for the probing image and the reference template, and determining a tip shape of a tip of the probe under detection according to the grayscale matrix; determining a plurality of tip perpendicular lines relative to an extension direction of the probe under detection from the first image, detecting the plurality of tip perpendicular lines line by line until a target grayscale point is detected, and determining a position of the target grayscale point as a tip position; and obtaining a probe tip detection result based on the tip shape and the tip position.

According to some embodiments of the present disclosure, aligning the probing image with the reference template includes: selecting a first grayscale region from the reference template and establishing a first grayscale matrix corresponding to the first grayscale region; selecting a second grayscale region from the probing image and establishing a second grayscale matrix corresponding to the second grayscale region, where at least two different grayscale values exist in the first grayscale region and the second grayscale region; subtracting the second grayscale matrix from the first grayscale matrix to obtain an alignment matrix; and adjusting the first grayscale region according to the alignment matrix until the reference template is aligned with the probing image.

According to some embodiments of the present disclosure, adjusting the first grayscale region according to the alignment matrix until the reference template is aligned with the probing image includes: summing an absolute value of each matrix element in the alignment matrix to obtain a matrix alignment value; comparing the matrix alignment value with a preset alignment value to obtain a comparison result, where the preset alignment value is an alignment threshold indicating alignment of the first grayscale region and the second grayscale region; in response to the comparison result indicating that the matrix alignment value is greater than the preset alignment value, determining a plurality of third grayscale regions from the reference template, and establishing a third grayscale matrix of each of the third grayscale regions; subtracting the second grayscale matrix from each of the third grayscale matrices in sequence to obtain a plurality of new matrix alignment values; and determining a target matrix alignment value from the plurality of new matrix alignment values, determining the third grayscale region corresponding to the target matrix alignment value as an alignment region with the second grayscale region, and aligning the reference template corresponding to the third grayscale region and the probing image corresponding to the second grayscale region based on the alignment region.

According to some embodiments of the present disclosure, the probing image and the reference template are of the same size; and establishing the grayscale matrix for the probing image and the reference template, and determining the tip shape of the tip of the probe under detection according to the grayscale matrix includes: establishing a binarized matrix based on a grayscale value of the reference template and establishing a fourth grayscale matrix based on a grayscale value of the probing image; correspondingly multiplying matrix elements of the binarized matrix by matrix elements of the fourth grayscale matrix to obtain a tip morphology matrix; and determining the tip shape of the probe under detection according to the tip morphology matrix.

According to some embodiments of the present disclosure, determining the tip shape of the probe under detection according to the tip morphology matrix includes: acquiring a tip grayscale threshold which is preset; and binarizing matrix elements in the tip morphology matrix according to the tip grayscale threshold, and determining the tip shape of the probe under detection according to the binarized tip morphology matrix.

According to some embodiments of the present disclosure, determining the plurality of tip perpendicular lines relative to the extension direction of the probe under detection from the first image includes: selecting two detection points from each of the probes under detection in the first image, and calculating a directional slope of the probe under detection according to coordinates of the two detection points; calculating a perpendicular slope of the tip based on the directional slope; and determining the plurality of tip perpendicular lines along a direction of the perpendicular slope.

According to some embodiments of the present disclosure, after obtaining the probe tip detection result based on the tip shape and the tip position, the method further includes: issuing an alarm signal in response to the probe tip detection result indicating that the tip of the probe under detection is deformed; or issuing an alarm signal in response to the probe tip detection result indicating that the tip of the probe under detection is outside a preset probing range, where the preset probing range is a range in which the tip of the probe under detection detects the target electronic component and is capable of obtaining a detection result.

To achieve the above objective, in accordance with a third aspect of the present disclosure, an embodiment provides a probe tip detection system, including: a probing image acquisition module configured for acquiring a first image captured when electronic components are probed by a probe under detection, and extracting a probing image of a target electronic component from the first image; an alignment module configured for aligning the probing image with a reference template, where the reference template is obtained by extracting the target electronic component in a second image, and the second image is captured when the target electronic component is not probed by the probe under detection; a tip shape determination module configured for establishing a grayscale matrix for the probing image and the reference template, and determining a tip shape of a tip of the probe under detection according to the grayscale matrix; a tip position determination module configured for determining a plurality of tip perpendicular lines relative to an extension direction of the probe under detection from the first image, detecting the plurality of tip perpendicular lines line by line until a target grayscale point is detected, and determining a position of the target grayscale point as a tip position; and a probe tip detection result obtaining module configured for obtaining a probe tip detection result based on the tip shape and the tip position.

To achieve the above objective, in accordance with a third aspect of the present disclosure, an embodiment provides an electronic device, including a memory and a processor. The memory has a computer program stored therein. The computer program, when executed by the processor, causes the processor to implement the probe tip detection method according to any one of the embodiments of the first aspect of the present disclosure.

To achieve the above objective, in accordance with a fourth aspect of the present disclosure, an embodiment provides a computer-readable storage medium, having a computer program stored therein. The computer program, when executed by a processor, causes the processor to implement the probe tip detection method according to any one of the embodiments of the first aspect of the present disclosure.

According to the probe tip detection method and system, the electronic device, and the storage medium provided by the present disclosure, a first image captured when electronic components are probed by a probe under detection is acquired, and a probing image of a target electronic component is extracted from the first image; the probing image is aligned with a reference template to identify the same region in the probing image, where the reference template is obtained by extracting the target electronic component in a second image, and the second image is captured when the target electronic component is not probed by the probe under detection; a grayscale matrix is established for the probing image and the reference template, and a tip shape of a tip of the probe under detection is determined according to different grayscale values; a plurality of tip perpendicular lines relative to an extension direction of the probe under detection are determined from the first image, the plurality of tip perpendicular lines are detected line by line to prevent the detection direction from coinciding with the extension direction of the probe under detection, until a target grayscale point having a different grayscale from that of other regions is detected, and a position of the target grayscale point is determined as a tip position; and finally, a probe tip detection result is obtained based on the tip shape and the tip position. By the present disclosure, the shape or position of probe tips can be identified without analyzing a large batch of test data, thereby improving the accuracy of identification results and the efficiency of identification.

### BRIEF DESCRIPTION OF DRAWINGS

FIG. 1 is a schematic structural diagram of a probe tip detection system according to an embodiment of the present disclosure;
FIG. 2 is a flowchart of a probe tip detection method according to an embodiment of the present disclosure;
FIG. 3a is a schematic structural diagram of hardware for testing probes through movement of a chuck according to an embodiment of the present disclosure;
FIG. 3b is another schematic structural diagram of hardware for testing probes through movement of a chuck according to an embodiment of the present disclosure;
FIG. 3c is a schematic structural diagram of hardware for testing probes through movement of a probe positioner according to an embodiment of the present disclosure;
FIG. 3d is a schematic structural diagram of hardware for testing probes through movement of a probe card according to an embodiment of the present disclosure;
FIG. 4 is a schematic diagram of a first image according to an embodiment of the present disclosure;
FIG. 5 shows a probing image of a target electronic component extracted from a first image according to an embodiment of the present disclosure;
FIG. 6 is a schematic diagram of extracting a reference template according to an embodiment of the present disclosure;
FIG. 7 is a schematic diagram of aligning a probing image with a reference template according to an embodiment of the present disclosure;
FIG. 8 is a flowchart of S204 in FIG. 7;
FIG. 9a is a diagram of selecting a second grayscale region according to an embodiment of the present disclosure;
FIG. 9b is a diagram of selecting a first grayscale region according to an embodiment of the present disclosure;
FIG. 9c is a diagram of selecting a third grayscale region according to an embodiment of the present disclosure;
FIG. 10 is a flowchart of S103 in FIG. 2;
FIG. 11a is a schematic diagram of cropping a target region in a probing image according to an embodiment of the present disclosure;
FIG. 11b is a schematic diagram of cropping a target region in a reference template according to an embodiment of the present disclosure;
FIG. 12 is a flowchart of S403 in FIG. 10;
FIG. 13 is a flowchart of determining a plurality of tip perpendicular lines relative to an extension direction of the probe under detection from the first image according to an embodiment of the present disclosure;
FIG. 14 is a diagram showing search based on probe perpendicular lines according to an embodiment of the present disclosure;
FIG. 15 is an enlarged view of searching for an intersection point between a tip perpendicular line and the tip of the probe under detection according to an embodiment of the present disclosure;
FIG. 16 is a schematic block diagram of a probe tip detection system according to an embodiment of the present disclosure; and
FIG. 17 is a schematic structural diagram of hardware of an electronic device according to an embodiment of the present disclosure.

### DETAILED DESCRIPTION

In order to make the objectives, technical schemes, and advantages of the present disclosure clearer, the present disclosure is described in further detail below in conjunction with the accompanying drawings and embodiments. It should be understood that specific embodiments described herein are only used to illustrate the present disclosure, and are not intended to limit the present disclosure.

It is to be noted, although functional modules have been divided in the schematic diagrams of apparatuses and logical orders have been shown in the flowcharts, in some cases, the modules may be divided in a different manner, or the steps shown or described may be executed in an order different from the orders as shown in the flowcharts. The terms such as "first", "second" and the like in the description, the claims, and the accompanying drawings are used to distinguish similar objects, and are not necessarily used to describe a specific sequence or a precedence order.

Unless otherwise defined, meanings of all technical and scientific terms used in this specification are the same as those usually understood by those having ordinary skills in the art to which the present disclosure belongs. Terms used in this specification are merely intended to describe objectives of the embodiments of the present disclosure, but are not intended to limit the present disclosure.

As important consumables in semiconductor testing, probes are used in the design verification, wafer testing, and finished product testing processes to detect product design defects and manufacturing defects, and play an important role in ensuring the product yield, controlling costs, guiding chip design and process improvement, and so on.

The detection of the tip shape and the tip position of the probe is particularly important. The quality and shape of the tip of the probe directly affect the accuracy and repeatability of the test. Damage, wear, deformation, or other anomalies of the tip will lead to test errors and instability. Therefore, the shape of the tip needs to be detected. However, semiconductor devices generally have a small lead pitch and pad pitch. Inaccurate positioning of the probe tip will easily damage the device leads or cause erroneous measurement. Therefore, the position of the probe tip needs to be detected to ensure that the probe correctly contacts a lead or pad of the device.

In the related art, generally, a fault of a probe cannot be found unless continuous batches of semiconductor test data obtained using the probe are abnormal. Furthermore, the shape and position of the probe tip still need to be identified visually, which can easily lead to inaccurate identification results and low identification efficiency.

Based on this, embodiments of the present disclosure provide a probe tip detection method and system, an electronic device, and a storage medium, which can identify the shape or position of probe tips without analyzing a large batch of test data, thereby improving the accuracy of identification results and the efficiency of identification.

The probe tip detection method and system, the electronic device, and the storage medium provided in the embodiments of the present disclosure will be described in detail through the following embodiments. The probe tip detection method in the embodiments of the present disclosure is described first.

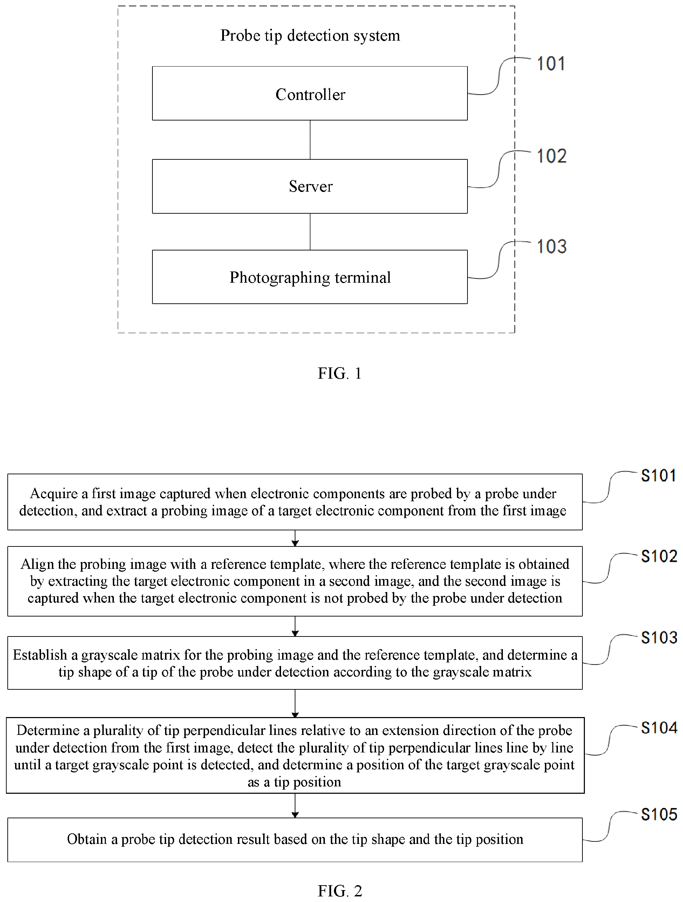

Referring to FIG. 1, in some embodiments, a probe tip detection system includes a controller 101, a server 102, and a photographing terminal 103.

The controller 101 may be a nerve center and command center of the probe tip detection system. The controller 101 may generate an operation control signal according to an instruction operation code and a timing signal to control the server 102 and the photographing terminal 103. The server 102 may be a computer or a group of computers, and may receive image data from the controller 101 and the photographing terminal 103, and analyze, process, and store the image data. The photographing terminal 103 may be various electronic devices having a photographing function, and may include a lens, an image sensor, an adapter, a light source, a focusing mechanism, etc. In a specific implementation, the photographing terminal 103 may be an image capture device such as a camera or a video recorder, or may be a smart phone, a handheld processing device, a tablet computer, a mobile notebook, a virtual reality device, an integrated handheld device, etc. The photographing terminal 103 may transmit a captured probe image or the like to the server 102 for processing and analysis to obtain a probe tip detection result.

The probe tip detection method in the embodiments of the present disclosure may be described below through the following embodiments.

It should be noted that in the specific embodiments of the present disclosure, when related processing needs to be performed according to data related to an identity or characteristic of a user, such as user information, user behavior data, user history data, and user location information, the user's permission or consent will be obtained first, and the collection, use, and processing of such data will comply with relevant laws, regulations, and standards. In addition, in the embodiments of the present disclosure, when sensitive personal information of the user needs to be acquired, a pop-up window is displayed or a confirmation page is redirected to for obtaining the user's individual permission or consent. Only after the user's individual permission or consent is explicitly obtained, user-related data necessary for the normal implementation of the embodiments of the present disclosure can be acquired.

FIG. 2 is an optional flowchart of a probe tip detection method according to an embodiment of the present disclosure. The method in FIG. 2 may include, but is not limited to, the following steps S101 to S105.

At S101, a first image captured when electronic components are probed by a probe under detection is acquired, and a probing image of a target electronic component is extracted from the first image.

It can be understood that the probe under detection is a probe to be detected. The probe is a tool for testing and measuring the performance of electronic devices. In the field of semiconductors, probes are widely used to test and analyze integrated circuits and other electronic components. The electronic components may be electronic components on integrated circuits, electronic components on wafers or printed circuit board assemblies (PCBAs), etc. The probes are typically very fine and sharp metal peaks or needle-shaped structures, which are configured for slight contact with a conductive surface of a component to be tested, so as to test the component.

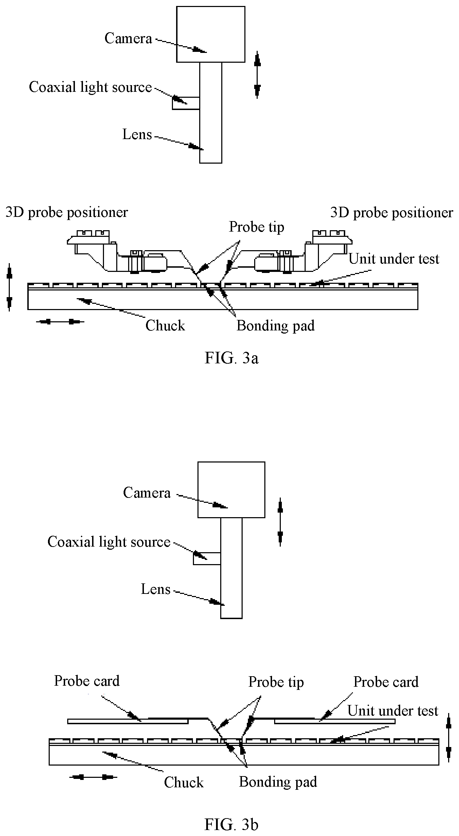

Refer to FIG. 3a to FIG. 3c. FIG. 3a to FIG. 3c are schematic structural diagrams of hardware for testing probes according to an embodiment of the present disclosure. It can be understood that a unit under test is an object tested using the probe under detection, e.g., a PCBA, a wafer, etc. The unit under test may be placed on a chuck. The chuck is provided with the probe under detection. The probe may be placed in a probe positioner or in a probe card. The chuck is movable in a horizontal direction to switch between electronic components under test. For example, the unit under test is moved to below the probe, the target electronic component is aligned with a tip of the probe, and the chuck is moved upward or the probe is moved downward to achieve contact between the probe under detection and the target electronic component. For example, if the unit under test is a wafer, the probe tip is configured for performing a probing test on a bonding pad on the wafer.

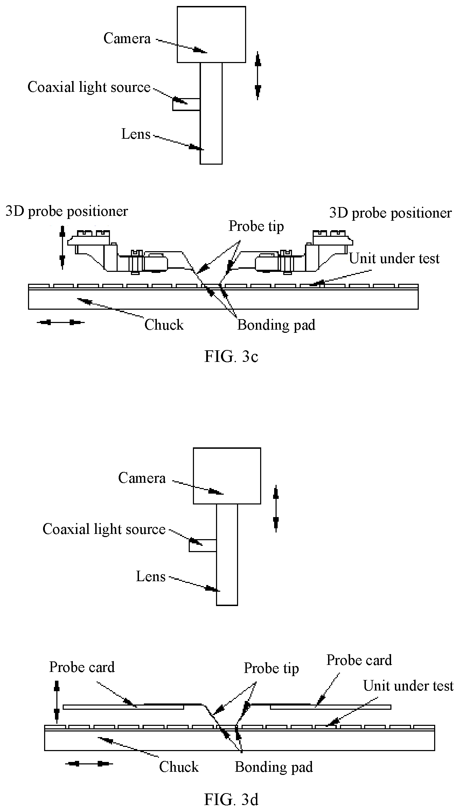

As shown in FIG. 3a, the probe under detection is placed in a probe positioner, and the probe under detection and the target electronic component are brought into contact by moving the chuck vertically. As shown in FIG. 3b, the probe under detection is placed in a probe card, and the probe under detection is brought into contact with the target electronic component by moving the chuck vertically. As shown in FIG. 3c, the probe under detection is placed in a probe positioner, and the probe under detection and the target electronic component are brought into contact by moving the probe positioner vertically. As shown in FIG. 3d, the probe under detection is placed in a probe card, and the probe under detection is brought into contact with the target electronic component by moving the probe card vertically.

FIG. 3a to FIG. 3c also show a device for capturing images in the present disclosure, which, for example, may capture a first image, a second image, etc. The device is movable vertically, and may be a camera module, a video recorder, a camera, a scanner, or other devices having a photographing function such as a mobile phone, a tablet computer, etc. When the device for capturing images is a camera, the camera further includes a coaxial light source and a lens. Different photographing effects and imaging representations can be realized by adjusting parameters of the coaxial light source and the lens.

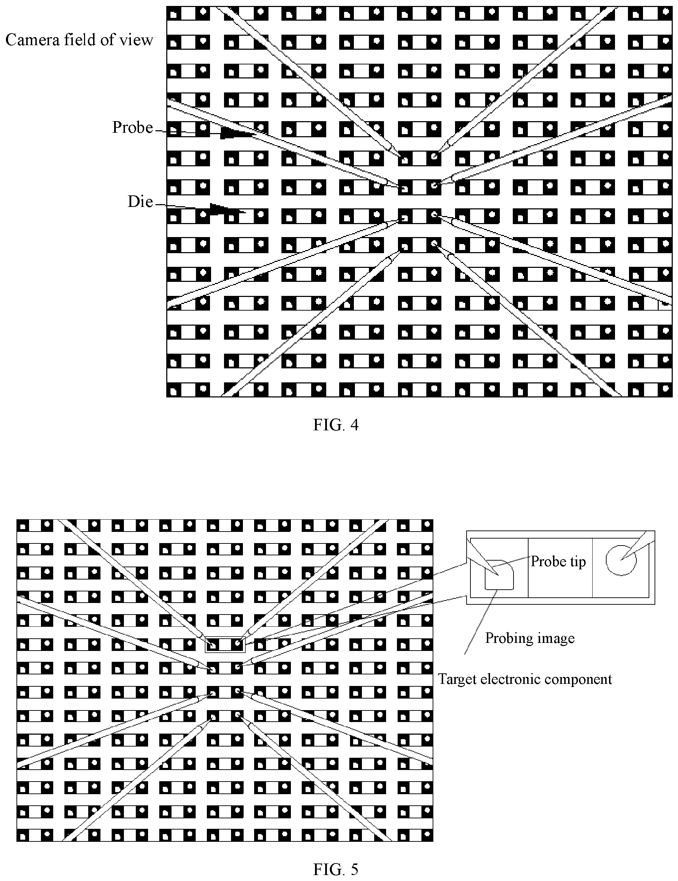

Refer to FIG. 4 and FIG. 5. FIG. 4 shows a first image. FIG. 5 shows a probing image of a target electronic component extracted from a first image. It can be understood that, in order to acquire the tip shape and the tip position of the probe under detection, a designated region of an electronic component, e.g., a bonding pad in a die, needs to be probed with the probe under detection. During probing using the probe, an image of the probing may be captured as a first image, and then a probing image of the probe under detection is extracted from the first image. It can be understood that the designated region is typically a region where the probe under detection can correctly test the electronic component under test and obtain a test result.

In some embodiments, the probe may be pressed into a thin sheet that is prone to being marked. The thin sheet may simulate an arrangement of electronic components, or a specific region to be detected may be set on the thin sheet, so that probe tip detection can be implemented even when no electronic component is present. For example, a layer of thin sheet which is prone to being marked by the probe may be adhered to the chuck, and after the thin sheet is probed by the probe, probing marks can be easily left on the thin sheet, thereby facilitating detection of the probe and preventing damage to the probe during probe calibration. In some embodiments, the thin sheet may be a consumable such as copper foil, aluminum foil adhesive tape, etc. that is prone to probing marks.

At S102, the probing image is aligned with a reference template, where the reference template is obtained by extracting the target electronic component in a second image, and the second image is captured when the target electronic component is not probed by the probe under detection.

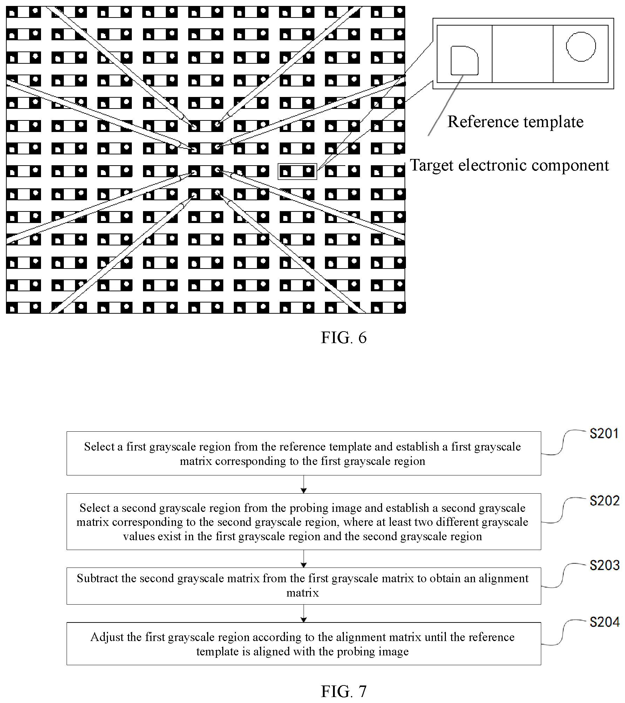

In some embodiments, an image of the unit under test including the target electronic component may be acquired as the second image before or after the target electronic component is probed by the probe under detection. In other words, in the second image, no probe tip exists, and only the unit under test exists. It can be understood that the first image should be captured at the same angle as the second image as much as possible. If the angles are different, the camera should be moved to the same angle or the image should be adjusted. If the electronic components in the unit under test are arranged uniformly, as shown in FIG. 6, the shape of the target electronic component is also consistent with the shapes of other electronic components. In this case, only the first image of probing needs to be captured, the probing image corresponding to the target electronic component is extracted from the first image, and the reference template is extracted from another electronic component in the first image. For example, if the target electronic component is a first electronic component, a second electronic component is an electronic component which is in the same unit under test as the first electronic component but is not under test, and the structure and shape of the first electronic component are consistent with those of the second electronic component, the second electronic component may be extracted as the reference template and aligned with the probing image of the first electronic component. This obviates the need to capture two images, and therefore can greatly reduce the test time. Alternatively, if the unit under test has been tested previously, and a position from which the reference template is to be extracted is consistent with the position of the probing image of the target electronic component to be tested this time, a historical reference template used in the previous test may be directly used as the reference template for the current test without capturing the second image, thereby reducing the test time and improving the test efficiency.

For example, two regions are extracted from the probing image and the reference template respectively, and grayscale matrices of the two regions are calculated. If there is a difference between the grayscale matrices, the region extracted in the reference template is moved, and a grayscale matrix of the region extracted in the reference template after the movement is calculated. When there is no difference between the grayscale matrices of the two regions extracted from the probing image and the reference template or the difference can be ignored, it means that the probing image and the reference template have been aligned according to the two regions. Thus, specific elements, e.g., bonding pads, in the probing image and the reference template can be aligned.

At S103, a grayscale matrix is established for the probing image and the reference template, and a tip shape of a tip of the probe under detection is determined according to the grayscale matrix.

In some embodiments, grayscale matrices are established for the probing image and the reference template; the matrix elements of the two grayscale matrices are multiplied correspondingly to obtain a new grayscale matrix; and the new grayscale matrix is compared with a preset grayscale threshold, where a matrix element greater than the grayscale threshold is determined as a mark left by the probe under detection and a matrix element less than the grayscale threshold is determined as a region not probed by the probe under detection, or a matrix element greater than the grayscale threshold is determined as a region not probed by the probe under detection and a matrix element less than the grayscale threshold is determined as a mark left by the probe under detection. As such, the tip shape left on the target electronic component after probing with the tip of the probe under detection can be quickly and accurately determined.

At S104, a plurality of tip perpendicular lines relative to an extension direction of the probe under detection are determined from the first image, the plurality of tip perpendicular lines are detected line by line until a target grayscale point is detected, and a position of the target grayscale point is determined as a tip position.

In some embodiments, if the tip position is directly determined according to the captured first image or other images, the image needs to be enlarged, which may cause the image to become blurred or lose details due to the limitation of resolution, resulting in low accuracy. In addition, because the image is captured from top to bottom by a camera, the determination of the tip position may be interfered with by images of other portions of the probe (e.g., the probe body). Moreover, the tip position needs to be identified visually, which results in low efficiency and low accuracy. To solve these problems, in some embodiments, a directional slope of the extension direction of the probe under detection is determined from the first image, then a perpendicular slope of the directional slope is calculated, and a plurality of tip perpendicular lines perpendicular to the probe tip are determined according to the perpendicular slope.

It can be understood that since other portions of the probe have the same grayscale as that of the tip, tip perpendicular lines need to be set, to prevent the search range from coinciding with the extension direction of the probe, i.e., to avoid finding other portions of the probe other than the tip, which may otherwise affecting the determination of the tip position. Since the grayscale value of the point where the tip is located is different from those of surrounding regions, e.g., the grayscale value of the tip is different from the grayscale value of the target electronic component, the perpendicular lines may be detected line by line to determine a target grayscale point, and the position of the target grayscale point may be determined as the tip position. Thus, the efficiency and accuracy of determining the tip position can be greatly improved.

At S105, a probe tip detection result is obtained based on the tip shape and the tip position.

The probe tip detection may be performed periodically. For example, the first image and the second image are captured every 5 minutes or 30 minutes to acquire the tip shape and the tip position of the probe. In some scenarios that require high precision of the probe under detection, images may be captured and analyzed in real time to obtain the tip shape and the tip position. The manner in which the probe tip detection is performed may be adjusted as required, which is not limited in the present disclosure.

It can be understood that the number of probes under detection may be one or more, for example, 2, 4, etc. When a plurality of probes under detection are detected, it is feasible to capture only a first image, and then analyze tip shapes and tip positions of the plurality of probes under detection one by one, thereby improving the detection efficiency.

It can be understood that if the tip shape of the probe is unqualified, e.g., the tip shape may be bent, misaligned, worn, etc., or if the tip position is not in a preset range (e.g., in the middle of the target electronic component), the probe under detection may be determined to be unqualified. For example, when the probe tip is detected based on the tip shape and the tip position, the analysis may be performed by inspection personnel based on the grayscale matrix and the tip position, or may be performed by a pre-trained neural network. The neural network may be trained with qualified grayscale matrices and tip positions, or trained with images of qualified probes under detection, to have the capability to detect an unqualified probe under detection, thereby achieving more efficient probe tip detection.

According to the probe tip detection method and system, the electronic device, and the storage medium provided by the present disclosure, a first image captured when electronic components are probed by a probe under detection is acquired, and a probing image of a target electronic component is extracted from the first image; the probing image is aligned with a reference template to identify the same region in the probing image, where the reference template is obtained by extracting the target electronic component in a second image, and the second image is captured when the target electronic component is not probed by the probe under detection; a grayscale matrix is established for the probing image and the reference template, and a tip shape of a tip of the probe under detection is determined according to different grayscale values; a plurality of tip perpendicular lines relative to an extension direction of the probe under detection are determined from the first image, the plurality of tip perpendicular lines are detected line by line to prevent the detection direction from coinciding with the extension direction of the probe under detection, until a target grayscale point having a different grayscale from that of other regions is detected, and a position of the target grayscale point is determined as a tip position; and finally, a probe tip detection result is obtained based on the tip shape and the tip position. By the present disclosure, the shape or position of probe tips can be identified without analyzing a large batch of test data, thereby improving the accuracy of identification results and the efficiency of identification.

Referring to FIG. 7, in some embodiments, aligning the probing image with the reference template may include the following steps S201 to S204.

At S201, a first grayscale region is selected from the reference template, and a first grayscale matrix corresponding to the first grayscale region is established.

In some embodiments, a first grayscale region may be determined from the reference template in advance for subsequent alignment with a second grayscale region determined from the probing image, so as to determine a search range according to the reference template and the probing image that have been aligned. Generally, a region having a grayscale value significantly different from other regions in the reference template is selected as the first grayscale region, so that the first grayscale matrix established accordingly has distinct differentiation, to facilitate subsequent calibration. For example, if the unit under test is a wafer, a bonding pad on a die generally appear as a highlighted region in the image, and grayscale values of regions surrounding the bonding pad are significantly different from that of the bonding pad. Therefore, both the bonding pad and the region surrounding the bonding pad may be selected as the first grayscale region, and a first grayscale matrix is established based on grayscale values of the first grayscale region.

At S202, a second grayscale region is selected from the probing image, and a second grayscale matrix corresponding to the second grayscale region is established, where at least two different grayscale values exist in the first grayscale region and the second grayscale region.

Similarly, a second grayscale region is selected by the same the method as that of selecting the first grayscale region, i.e., a region having a grayscale value significantly different from other regions in the probing image is selected as the second grayscale region, and a second grayscale matrix is established according to the second grayscale region. It can be understood that there are at least two different grayscale values or a plurality of different grayscale values in the first grayscale region and the second grayscale region, and the more grayscale values in the selected first grayscale region and second grayscale region, the easier it is to align the first grayscale region and the second grayscale region.

At S203, the second grayscale matrix is subtracted from the first grayscale matrix to obtain an alignment matrix.

For example, if the first grayscale matrix (defined as A) established according to the first grayscale region is expressed as $A = \left|\begin{matrix}{a}_{11} & {a}_{12} & … \\ {a}_{21} & … & … \\ … & … & {a}_{ij}\end{matrix}\right| ,$ and the second grayscale matrix (defined as B) established according to the second grayscale region is expressed as $B = \left|\begin{matrix}{b}_{11} & {b}_{12} & … \\ {b}_{21} & … & … \\ … & … & {b}_{ij}\end{matrix}\right| ,$ an alignment matrix C may be obtained by subtracting the second grayscale matrix from the first grayscale matrix (or subtracting the first grayscale matrix from the second grayscale matrix), i.e., C = A - B, which is expressed as: $C = \left|\begin{matrix}{a}_{11} - {b}_{11} & {a}_{12} - {b}_{12} & … \\ {a}_{21} - {b}_{21} & … & … \\ … & … & {a}_{ij} - {b}_{ij}\end{matrix}\right| .$

A gray difference between the first grayscale matrix and the second grayscale matrix can be obtained by analyzing the alignment matrix. It can be understood that if there is no difference between elements of the two matrices, the result of the subtraction should be 0, and if there is a difference between elements of the two matrices, the result of the subtraction should not be 0.

At S204, the first grayscale region is adjusted according to the alignment matrix until the reference template is aligned with the probing image.

In some embodiments, if each element of the alignment matrix C is not 0 or is greater than a preset alignment value, it means that the first grayscale region and the second grayscale region are not aligned. In this case, it is feasible to move the first grayscale region and recalculate the alignment matrix, until the reference template and the probing image are aligned.

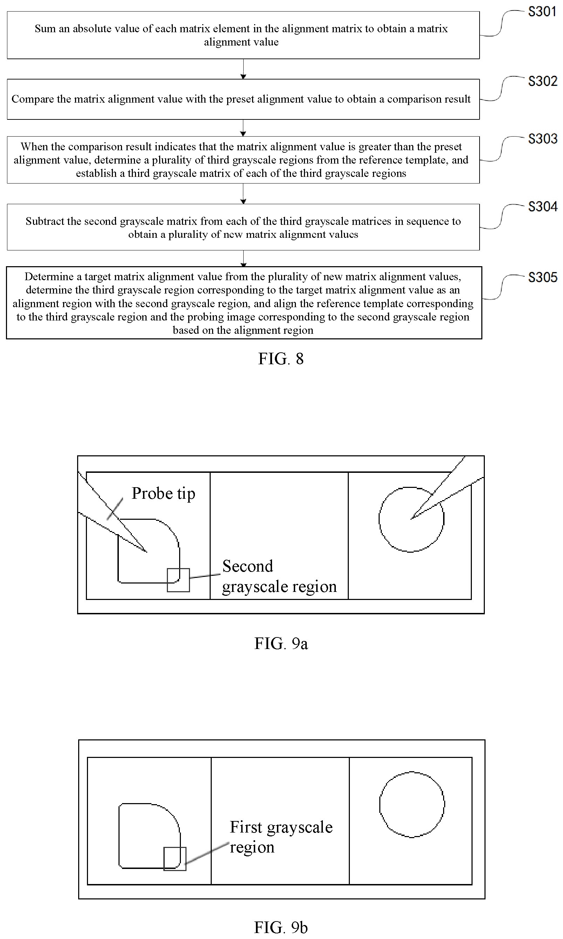

Referring to FIG. 8, in some embodiments, S204 may include the following steps S301 to S305.

At S301, an absolute value of each matrix element in the alignment matrix is summed to obtain a matrix alignment value.

In some embodiments, an alignment matrix (defined as C) may be obtained by subtracting the second grayscale matrix (defined as B) from the first grayscale matrix (defined as A). C is expressed as: $C = \left|\begin{matrix}{a}_{11} - {b}_{11} & {a}_{12} - {b}_{12} & … \\ {a}_{21} - {b}_{21} & … & … \\ … & … & {a}_{ij} - {b}_{ij}\end{matrix}\right| .$

Further, an absolute value of each matrix element in the matrix C may be summed to obtain a new function *f* : $f = \sum \sum \left|{a}_{ij}-{b}_{ij}\right| .$

Finally, a value of *f* is calculated as a matrix alignment value, and the difference between the first grayscale matrix and the second grayscale matrix can be more intuitively determined according to the matrix alignment value.

At S302, the matrix alignment value is compared with a preset alignment value to obtain a comparison result, where the preset alignment value is an alignment threshold indicating alignment of the first grayscale region and the second grayscale region.

In some embodiments, a preset alignment value may be set as an alignment threshold for the first grayscale region and the second grayscale region. The preset alignment value is a maximum allowable value of the matrix alignment value. If the matrix alignment value exceeds the preset alignment value, it means that the first grayscale region and the second grayscale region cannot be aligned, i.e., the first grayscale region and the second grayscale region do not belong to the same region. It can be understood that the preset alignment value may be selected according to experience or requirements.

At S303, when the comparison result indicates that the matrix alignment value is greater than the preset alignment value, a plurality of third grayscale regions are determined from the reference template, and a third grayscale matrix of each of the third grayscale regions is established.

In some embodiments, the preset alignment value is set to 3. If the matrix alignment value is 2, because 2 is less than 3, the comparison result indicates that the matrix alignment value is less than or equal to the preset alignment value, indicating that the difference between the first grayscale matrix and the second grayscale matrix is tolerable, and the first grayscale region and the second grayscale region are aligned. If the matrix alignment value is 5, because 5 is greater than 3, the comparison result indicates that the matrix alignment value is greater than the preset alignment value, indicating that the difference between the first grayscale matrix and the second grayscale matrix is not tolerable. In this case, a plurality of third grayscale regions may be re-determined by gradually moving the reference template. For example, the reference template may be moved upward, downward, leftward, or rightward according to a pixel step length. Each time the reference template is moved by the pixel step length, a third grayscale region is obtained. The specific pixel step length may be determined according to actual requirements, which is not particularly limited in the embodiments of the present disclosure.

It can be understood that the third grayscale region may also be determined by randomly moving the reference template, instead of moving the reference template according to a preset pixel step length. In addition, the first grayscale region, the second grayscale region, and the third grayscale region that are selected should be in the same direction as much as possible. For example, if the unit under test is a wafer, and the probe under detection is pressed on a bonding pad in the reference image, the first grayscale region, the second grayscale region, and the third grayscale region may be selected from a lower right corner of the bonding pad, to facilitate quick calculation and alignment. The first grayscale region, the second grayscale region, and the third grayscale region may also be selected from other positions of the bonding pad depending on actual situations.

In some embodiments, a third grayscale matrix may be established according to the determined plurality of third grayscale regions to facilitate recalculation of the matrix alignment value for each third grayscale matrix. It can be understood that in order to facilitate addition and subtraction between the grayscale matrices, the first grayscale region, the second grayscale region, and the third grayscale region that are selected should be of the same size; otherwise, redundant data need to be removed.

At S304, the second grayscale matrix is subtracted from each of the third grayscale matrices in sequence to obtain a plurality of new matrix alignment values.

The third grayscale matrix may be defined as A*ᵢⱼ*. Each time the reference template is moved by one pixel step length, a new third grayscale matrix is obtained, i.e., a new A*ᵢⱼ* is obtained. After the reference template is moved by all possible pixel step lengths, third grayscale matrices corresponding to all possible third grayscale regions are obtained. The second grayscale matrix is subtracted from each third grayscale matrix, or the third grayscale matrix is subtracted from each second grayscale matrix, to obtain a plurality of new alignment matrices, which is expressed as: ${C}_{ij} = {A}_{ij} - B .$

In some embodiments, matrix alignment values of the plurality of new alignment matrices may be calculated. The method of calculating the matrix alignment value has been described above, so the details will not be repeated herein. After the matrix alignment value of each alignment matrix is calculated, a matrix *D* may be established according to the matrix alignment values, to facilitate the comparison of the matrix alignment values. The matrix *D* is expressed as: $D = \left|\begin{matrix}{f}_{11} & {f}_{12} & … \\ {f}_{21} & … & … \\ … & … & {f}_{ij}\end{matrix}\right| .$

At S305, a target matrix alignment value is determined from the plurality of new matrix alignment values, the third grayscale region corresponding to the target matrix alignment value is determined as an alignment region with the second grayscale region, and the reference template corresponding to the third grayscale region and the probing image corresponding to the second grayscale region are aligned based on the alignment region.

It can be understood that since the matrix *D* is generated according to the matrix alignment values that are obtained by moving the reference template based on the pixel step length, the matrix *D* covers all possible third grayscale regions that can be aligned with the second grayscale region. In this case, a smallest matrix alignment value is selected from the matrix *D* , the third grayscale region corresponding to the third grayscale matrix corresponding to the smallest matrix alignment value is determined as an alignment region with the second radian region, and the reference template corresponding to the third grayscale region and the probing image corresponding to the second grayscale region are aligned based on the alignment region for further calculation.

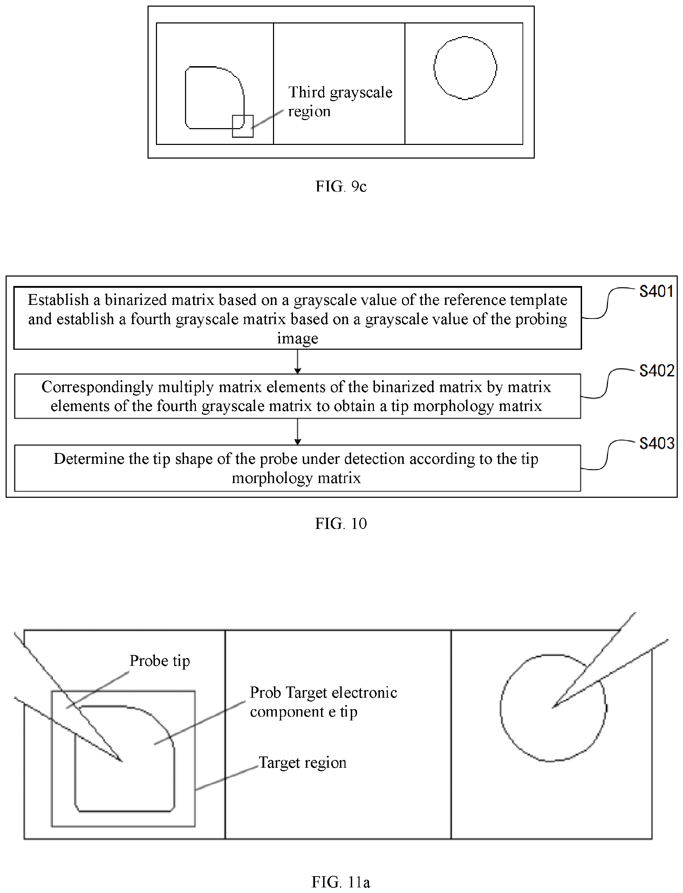

Refer to FIG. 9a to FIG. 9c. FIG. 9a shows a probing image, where the extracted part is a second grayscale region. FIG. 9b and FIG. 9c show a reference template. The extracted part in FIG. 9b is a first grayscale region. The extracted part in FIG. 9c is a third grayscale region. It can be seen from FIG. 9a and FIG. 9b that the first grayscale region and the second grayscale region are not aligned. As can be seen from FIG. 9a and FIG. 9c, the first grayscale region and the third grayscale region are already aligned, i.e., the target region in the probing image and the target region in the reference template are already aligned. It can be understood that the target region is generally a region probe-tested by the probe, i.e., a region where the target electronic component is located. For example, if a wafer is tested, the target region may be a bonding pad region on a die.

Referring to FIG. 10, in some embodiments, the probing image and the reference template are of the same size; and S103 may include the following steps S401 to S403.

At S401, a binarized matrix is established based on a grayscale value of the reference template, and a fourth grayscale matrix is established based on a grayscale value of the probing image.

In some embodiments, after the target region in the probing image and the target region in the reference template are aligned, the target region may be selected. For example, if the unit under test is a wafer, the target region may be a bonding pad region. After the target region is identified, the probing image and the reference template may be cropped again, so as to remove redundant parts and retain only the part probed by the probe under detection, i.e., the parts where the aligned target regions are located, thereby improving the detection efficiency.

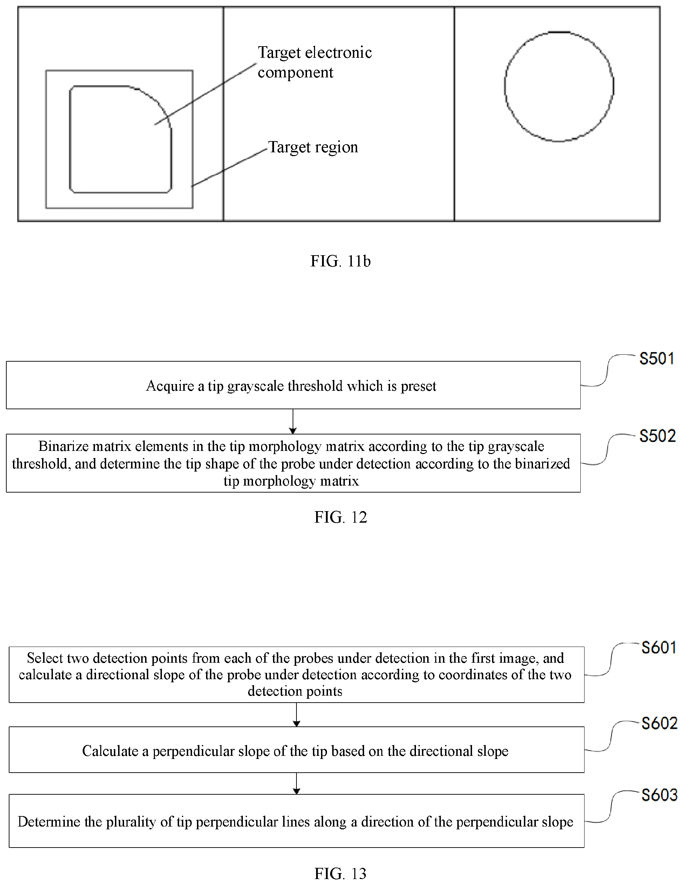

Refer to FIG. 11a and FIG. 11b. FIG. 11a and FIG. 11b are schematic diagrams of cropping a target region. FIG. 11a is a schematic diagram of cropping a target region in a probing image, where the position of the target region has been indicated in the figure. FIG. 11b is a schematic diagram of cropping a target region in a reference template, where a part where an electronic component is extracted is the target region. The target regions in FIG. 11a and FIG. 11b are both regions in which the target electronic component is aligned. To be specific, the positions of the target electronic component in the two target regions in FIG. 11a and FIG. 11b are the same. It can be understood that since the process of aligning the target region in the probing image and the target region in the reference template has been described in detail above, the details will not be repeated herein.

It can be understood that instead of cropping the target region, it is also feasible to remove redundant data of the probing image and the reference template, and after the redundant data is removed, the remaining part of the probing image and the remaining part of the reference template should be aligned to facilitate subsequent calculation. The redundant data may be manually removed by inspection personnel, or may be removed using an algorithm, which is not particularly limited in the embodiments of the present disclosure.

In some embodiments, after the target region in the reference template and the target region in the probing image are cropped, a binarized matrix may be established according to the target region cropped from the reference template. Generally speaking, a grayscale matrix may be established for the target region cropped from the reference template, and a grayscale threshold is set. Since the target electronic component is often highlighted in the image, a part having a grayscale value greater than the grayscale threshold is determined as the target electronic component, and a part having a grayscale value less than the grayscale threshold is determined as a non-target electronic component. Establishing a grayscale matrix for the target region in the reference template is setting a part having a grayscale value greater than the grayscale threshold (which is, for example, set to 210) to 1, and setting a part having a grayscale value less than the grayscale threshold to 0, so as to establish a binarized matrix (defined as *J*) of the reference template. For example, *J* may be expressed as: $J = \left|\begin{matrix}0 & 0 & … \\ 0 & … 1 … & … \\ … & … & 0\end{matrix}\right| .$

In the binarized matrix *J* , 1 represents the target electronic component and 0 represents a region where a non-target electronic component is located, so that the position and morphology of the target electronic component can be quickly distinguished.

Further, a fourth grayscale matrix (defined as *J*') may be established according to grayscale values of the target region cropped from the probing image. For example, *J'* may be expressed as: $J ′ = \left|\begin{matrix}{p}_{11} & {p}_{12} & … \\ {p}_{21} & p … & … \\ … & … & {p}_{ij}\end{matrix}\right| .$

It can be understood that the establishment of the fourth grayscale matrix according to the grayscale values of the target region cropped from the probing image facilitates identification of probing marks according to different grayscale values.

At S402, matrix elements of the binarized matrix are correspondingly multiplied by matrix elements of the fourth grayscale matrix to obtain a tip morphology matrix.

It can be understood that the matrix elements of the binarized matrix and the matrix elements of the fourth grayscale matrix are in one-to-one correspondence after the target electronic component is aligned. For example, if a matrix element at point A in the binarized matrix is at position B, a matrix element at point A in the fourth grayscale matrix is also at position B, and accordingly, the matrix element at point A and the matrix element at position B can be correspondingly multiplied. As such, the position of the tip of the probe under detection in the fourth grayscale matrix can be correctly mapped into the binarized matrix. It can be understood that if the matrix elements of the binarized matrix and the fourth grayscale matrix cannot be multiplied correspondingly due to existence of redundant data, the redundant data may be removed using a trained model to improve the accuracy of tip morphology identification.

In some embodiments, the matrix elements of the binarized matrix and the matrix elements of the fourth grayscale matrix may be correspondingly multiplied. the position of the target electronic component can be clearly identified based on the binarized matrix (where the position of the target electronic component is indicated by 1 in the binarized matrix, and a region where a non-target electronic component in the binarized matrix is indicated by 0). The matrix elements of the binarized matrix and the matrix elements of the fourth grayscale matrix are correspondingly multiplied to obtain a tip morphology matrix. Finally, the matrix elements which are 0 in the binarized matrix are also 0 in the tip morphology matrix. Therefore, a region defined by the matrix elements which are 0 in tip morphology matrix is a region where a non-target electronic component is located.

In some embodiments, a tip morphology matrix E may be obtained by correspondingly multiplying the matrix elements of the binarized matrix (defined as *J*) by the matrix elements of the fourth grayscale matrix (defined as *J'*). *J* is expressed as: $J = \left|\begin{matrix}0 & 0 & 0 & 0 & 0 \\ 0 & 1 & 1 & 1 & 0 \\ 0 & 1 & 1 & 1 & 0 \\ 0 & 1 & 1 & 1 & 0 \\ 0 & 0 & 0 & 0 & 0\end{matrix}\right| .$

*J*' is expressed as: $J ′ = \left[\begin{matrix}{p}_{11} & {p}_{12} & {p}_{13} & {p}_{14} & {p}_{15} \\ {p}_{21} & {p}_{22} & {p}_{23} & {p}_{24} & {p}_{25} \\ {p}_{31} & {p}_{32} & {p}_{33} & {p}_{34} & {p}_{35} \\ {p}_{41} & {p}_{42} & {p}_{43} & {p}_{44} & {p}_{45} \\ {p}_{51} & {p}_{52} & {p}_{53} & {p}_{54} & {p}_{55}\end{matrix}\right] .$

A result of the tip morphology matrix E is calculated as follows: $E = \left|\begin{matrix}0 * {p}_{11} & 0 * {p}_{12} & … \\ 0 * {p}_{21} & 1 . p . . & … \\ … & … & 0 * {p}_{ij}\end{matrix}\right| = \left|\begin{matrix}0 & 0 & 0 & 0 & 0 \\ 0 & {p}_{22} & {p}_{23} & {p}_{24} & 0 \\ 0 & {p}_{32} & {p}_{33} & {p}_{34} & 0 \\ 0 & {p}_{42} & {p}_{43} & {p}_{44} & 0 \\ 0 & 0 & 0 & 0 & 0\end{matrix}\right| .$

As can be seen from the above example, a region where a non-target electronic component is located is 0 in the binarized matrix, and is also 0 in the tip morphology matrix.

At S403, the tip shape of the probe under detection is determined according to the tip morphology matrix.

It can be understood that after the matrix elements which are 0 in the tip morphology matrix are determined as a non-target electronic component, the remaining matrix elements which are not 0 may be determined as a target electronic component, and since values of the matrix elements in a probed part are different from those in an unprobed part in the tip morphology matrix, the shape of the tip can be quickly determined according to different matrix elements, which is more intuitive and accurate than observing the probe visually.

Referring to FIG. 12, in some embodiments, S403 may include the following steps S501 to S502.

At S501, a tip grayscale threshold which is preset is acquired.

In some embodiments, since there may be slight differences in the values of matrix elements corresponding to the probing image of the probe under detection in the tip morphology matrix, for example, the grayscale value of a matrix element in the probed part of the probe under detection in the tip morphology matrix may be 3 or 10, a tip grayscale threshold may be set according to experience. For example, the tip grayscale threshold may be set to 50 (which may be adjusted according to actual situations). Since a shadow appears at the probed part, resulting in low grayscale values, the matrix elements less than or equal to the tip grayscale threshold may be determined as the probed part, and the matrix elements greater than the tip grayscale threshold may be determined as the unprobed part. As such, the tip shape can be more accurately determined.

At S502, matrix elements in the tip morphology matrix are binarized according to the tip grayscale threshold, and the tip shape of the probe under detection is determined according to the binarized tip morphology matrix.

In some embodiments, matrix elements in the tip morphology matrix may be binarized according to the tip grayscale threshold. For example, the matrix elements less than or equal to the tip grayscale threshold are set to 1, and the matrix elements greater than the tip grayscale threshold are set to 0, thus obtaining a binarized matrix.

It can be understood that in the binarized matrix, a region in which the matrix elements are 1 is a probed region, a region in which the matrix elements are not 1 is an unprobed region, and the shape of the tip can be quickly and intuitively determined according to the distribution of 1s in the binarized matrix, so as to determine where the tip has an anomaly such as wear and bending.

Referring to FIG. 13, in some embodiments, determining the plurality of tip perpendicular lines relative to the extension direction of the probe under detection from the first image may include the following steps S601 to S603.

At S601, two detection points are selected from each of the probes under detection in the first image, and a directional slope of the probe under detection is calculated according to coordinates of the two detection points.

It can be understood that it is difficult to determine the tip position of the probe under detection by observing the captured image visually, and the observation method is likely to cause eye fatigue of inspection personnel and an inaccurate analysis result; and since the resolution of the image is limited after the image is enlarged, the position of the tip cannot be accurately identified. Therefore, the present disclosure provides a scheme, which is described as follows. Two detection points are selected from each of the probes under detection in the first image. The detection points may be any two points that do not coincide with each other. Then, a directional slope of the probe under detection is calculated according to coordinates of the two detection points. The coordinates of the detection points may be acquired by establishing a coordinate system for the image.

At S602, a perpendicular slope of the tip is calculated based on the directional slope.

For example, a perpendicular slope of the tip may be calculated based on the directional slope, so that a plurality of perpendicular lines of the tip can be determined according to the perpendicular slope. For example, assuming that two points acquired along an extension direction of the tip of the probe under detection are respectively point a (*xₐ*, *yₐ*) and point b (*x*_{b}, *y_{b}*), a slope *k* between a and b is *k* = (*x_{b}* - *xₐ*)/(*y_{b}* - *yₐ*), and a perpendicular slope *k**^{'}*** of the tip is *k*^{'} = (-1) / *k*.

At S603, the plurality of tip perpendicular lines are determined along a direction of the perpendicular slope.

In some embodiments, the plurality of tip perpendicular lines may be determined along the direction of the perpendicular slope, to facilitate tip search. It can be understood that the determination of the tip perpendicular lines of the extension direction of the tip can avoid finding other portions of the probe under detection during search. For example, if the tip of the probe under detection is searched for along a straight line other than the tip perpendicular lines, it is highly likely that a non-tip portion of the probe under detection will be found; while similar problems will not occur if the search is performed along the perpendicular lines of the probe tip.

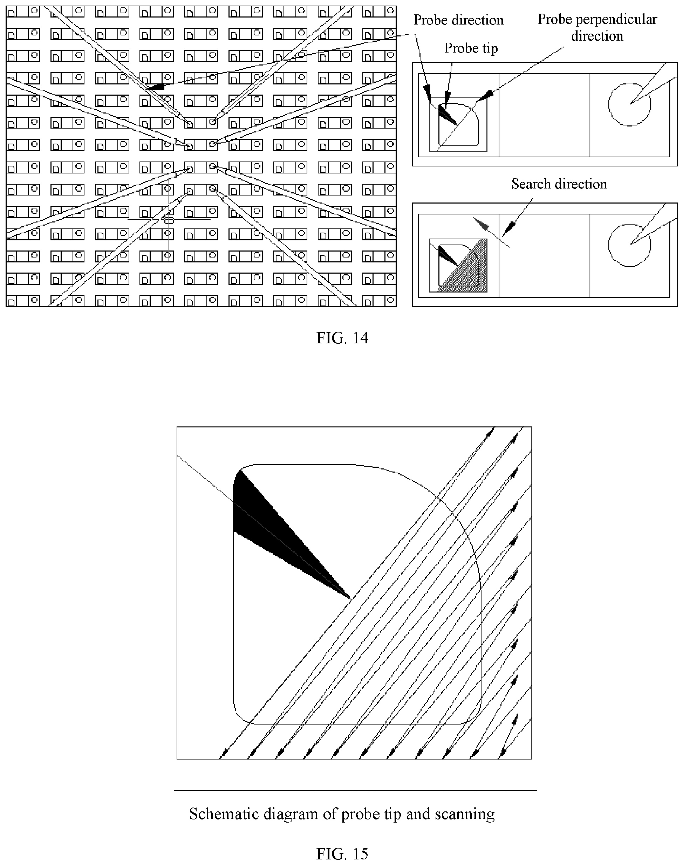

Refer to FIG. 14 and FIG. 15. A further explanation is given below with reference to FIG. 14 and FIG. 15. In FIG. 14, the probe direction, the probe perpendicular direction, and the search direction are indicated. FIG. 15 is a further enlarged view. It can be understood that the search may be performed starting from the relative position of the probe under detection in the first image (or in the probing image), and once the target grayscale point is detected, it means that the tip position is found.

It can be understood that the relative position of the tip direction may be described with reference to FIG. 14 and FIG. 15. FIG. 15 provides a schematic diagram of the tip of the probe under detection and scanning. When the probe is at the upper left corner, the search may be performed along the tip perpendicular lines in the lower right corner to avoid overlapping with other portions of the probe under detection. As for the target grayscale point, since the search starts from the relative position, most of the search range near the relative position is a region in which the target electronic component is not probed by the probe, i.e., a region with a high grayscale value. As the search proceeds along the search direction to an intersection point of a tip perpendicular line and the tip of the probe under detection, i.e., to the tip position of the tip, the grayscale value suddenly decreases at the tip position. For example, assuming that the grayscale value of other regions is 230, the grayscale value of the tip position (which is generally black) decreases significantly, for example, the grayscale value is 5. In this case, the tip position can be quickly detected according to the target grayscale point.

In some embodiments, a grayscale threshold may be set, and a point having a grayscale value lower than the grayscale threshold may be determined as a target grayscale point. A specific grayscale threshold may be set according to an actual situation, for example, may be set to a gray scale value of 30 or the like, which is not particularly limited in the embodiments of the present disclosure.

It can be understood that searching along the tip perpendicular lines can avoid interference from other non-tip portions of the probe under detection, and allows for quick identification of the tip position.

In some embodiments, after S105, the method may further include the following step S701 or S702.

At S701, an alarm signal is issued when the probe tip detection result indicates that the tip of the probe under detection is deformed.

In some embodiments, by observing the binarized tip morphology matrix, it can be quickly determined whether the tip of the probe under detection is deformed. For example, elements which are 1 in the binarized matrix represent the shape of the tip pressed on the electronic component under test. For example, if a shape defined by the elements which are 1 in the binarized matrix is a long strip, it means that the probe under detection is partially bent. Whether the probe under detection has an anomaly may be determined by inspection personnel according to experience, or may be analyzed and quickly determined by a trained model. If it is determined that the probe under detection has an anomaly, an alarm may be issued, to alert inspection personnel to promptly perform adjustment or maintenance. Further, if the probes under detection have been numbered in advance, the system may send out the serial number of the probe under detection when sending out the alarm signal, so as to distinguish between different probes under detection.

At S702, an alarm signal is issued when the probe tip detection result indicates that the tip of the probe under detection is outside a preset probing range, where the preset probing range is a range in which the tip of the probe under detection detects the target electronic component and is capable of obtaining a detection result.

In some embodiments, a probing range of the probe may be set in advance. For example, the probing range may be in the middle of the target electronic component. The size of the preset probing range may be set according to actual situations. If inspection personnel finds that the tip position of the probe under detection is outside the preset probing range by analyzing the probe position, or a pre-trained model detects that the tip position of the probe under detection is outside the preset probing range, an alarm signal is issued to alert inspection personnel to promptly deal with the abnormal probe under detection, so as to prevent the abnormal probe under detection from being further used to test the target electronic component. It can be understood that the preset probing range is a range in which the tip of the probe under detection detects the target electronic component and is capable of obtaining a normal detection result, and when the tip position of the probe under detection is outside the preset probing range, no detection result can be obtained even if probing is performed with the probe.

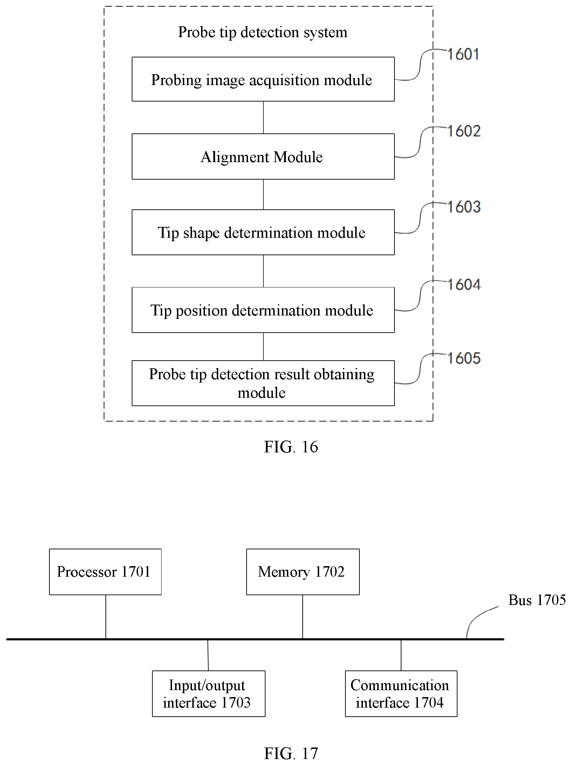

Referring to FIG. 16, an embodiment of the present disclosure further provides a probe tip detection system, which can implement the probe tip detection method and includes:
a probing image acquisition module 1601 configured for acquiring a first image captured when electronic components are probed by a probe under detection, and extracting a probing image of a target electronic component from the first image;
an alignment module 1602 configured for aligning the probing image with a reference template, where the reference template is obtained by extracting the target electronic component in a second image, and the second image is captured when the target electronic component is not probed by the probe under detection;
a tip shape determination module 1603 configured for establishing a grayscale matrix for the probing image and the reference template, and determining a tip shape of a tip of the probe under detection according to the grayscale matrix;
a tip position determination module 1604 configured for determining a plurality of tip perpendicular lines relative to an extension direction of the probe under detection from the first image, detecting the plurality of tip perpendicular lines line by line until a target grayscale point is detected, and determining a position of the target grayscale point as a tip position; and
a probe tip detection result obtaining module 1605 configured for obtaining a probe tip detection result based on the tip shape and the tip position.

Specific embodiments of the probe tip detection system are basically the same as the specific embodiments of the probe tip detection method, so the details will not be repeated herein. On the premise that the requirements of the embodiments of the present disclosure are met, the probe tip detection system may further include other functional modules to implement the probe tip detection method in the above embodiments.

An embodiment of the present disclosure further provides an electronic device, including a memory and a processor. The memory has a computer program stored therein. The computer program, when executed by the processor, causes the processor to implement the probe tip detection method. The electronic device may include any smart terminal such as a tablet computer or an in-vehicle computer.

FIG. 17 shows a hardware structure of an electronic device according to another embodiment. Referring to FIG. 17, the electronic device includes a processor 1701, a memory 1702, an input/output interface 1703, a communication interface 1704, and a bus 1705.

The processor 1701 may be implemented by a general-purpose Central Processing Unit (CPU), a microprocessor, an Application Specific Integrated Circuit (ASIC), or one or more integrated circuits, and is configured for executing a related program to implement the technical schemes provided by the embodiments of the present disclosure.

The memory 1702 may be implemented in the form of a Read Only Memory (ROM), a static storage device, a dynamic storage device, a Random Access Memory (RAM), etc. The memory 1702 may store an operating system and other application programs. When the technical schemes provided by the embodiments of the present disclosure are implemented by software or firmware, related program code is stored in the memory 1702, and is called by the processor 1701 to execute the probe tip detection method according to the embodiments of the present disclosure.

The input/output interface 1703 is configured for enabling input and output of information.

The communication interface 1704 is configured for realizing communication interaction between the electronic device and other devices, either through wired communication (e.g., USB, network cable, etc.) or through wireless communication (e.g., mobile network, Wi-Fi, Bluetooth, etc.).

The bus 1705 is configured for transmitting information between components of the electronic device (such as the processor 1701, the memory 1702, the input/output interface 1703, and the communication interface 1704).

The processor 1701, the memory 1702, the input/output interface 1703, and the communication interface 1704 are in communication connection with each other inside the electronic device through the bus 1705.

An embodiment of the present disclosure further provides a computer-readable storage medium, storing a computer program which, when executed by a processor, causes the processor to implement the probe tip detection method.

The memory, as a non-transitory computer-readable storage medium, may be configured for storing a non-transitory software program and a non-transitory computer-executable program. In addition, the memory may include a high-speed random access memory, and may also include a non-transitory memory, e.g., at least one magnetic disk storage device, flash memory device, or other non-transitory solid-state storage device. In some implementations, the memory may include memories located remotely from the processor, and the remote memories may be connected to the processor via a network. Examples of the network include, but are not limited to, the Internet, an intranet, a local area network, a mobile communication network, and combinations thereof.

The contents described in the embodiments of the present disclosure are for the purpose of illustrating the technical schemes of the embodiments of the present disclosure more clearly, and do not constitute a limitation on the technical schemes provided in the embodiments of the present disclosure. Those having ordinary skills in the art may know that with the evolution of technologies and the emergence of new application scenarios, the technical schemes provided in the embodiments of the present disclosure are also applicable to similar technical problems.

Those having ordinary skills in the art may understand that the technical scheme shown in the drawings does not constitute a limitation to the embodiments of the present disclosure, and more or fewer steps than those shown in the drawings may be included, or some steps may be combined, or different steps may be used.

The apparatus embodiments described above are merely examples. The units described as separate components may or may not be physically separated, i.e., may be located in one place or may be distributed over a plurality of network units. Some or all of the modules may be selected according to actual needs to achieve the objectives of the schemes of the embodiments of the present disclosure.

Those having ordinary skills in the art can understand that all or some of the steps in the methods disclosed above and the functional modules/units in the system and the apparatus can be implemented as software, firmware, hardware, and appropriate combinations thereof.

In the specification and accompanying drawings of the present disclosure, the terms "first," "second," "third," "fourth," and so on (if any) are intended to distinguish between similar objects but do not necessarily indicate a specific order or sequence. It is to be understood that the data termed in such a way are interchangeable in appropriate circumstances, such that the embodiments of the present disclosure described herein can be implemented in orders other than the order illustrated or described herein. Moreover, the terms "include," "comprise," and any other variants thereof mean are intended to cover a non-exclusive inclusion. For example, a process, method, system, product, or device that includes a list of steps or units is not necessarily limited to those expressly listed steps or units, but may include other steps or units not expressly listed or inherent to such a process, method, product, or device.

It is to be understood that in the present disclosure, "at least one" and "some" means one or more and "a plurality of" means two or more. The term "and/or" is used for describing an association between associated objects and representing that three associations may exist. For example, "A and/or B" may indicate that only A exists, only B exists, and both A and B exist, where A and B may be singular or plural. The character "/" generally indicates an "or" relationship between the associated objects. "At least one of" and similar expressions refer to any combination of items listed, including one item or any combination of a plurality of items. For example, at least one of a, b, or c may represent a, b, c, "a and b," "a and c," "b and c," or "a, b, and c," where a, b, and c may be singular or plural.

In the several embodiments provided in the present disclosure, it is to be understood that the disclosed system and method may be implemented in other manners. For example, the described system embodiments are only exemplary. For example, the division of the units is merely a logical function division and other division manners may be used in practical implementations. For example, a plurality of units or components may be combined or integrated into another system, or some features may be ignored or not performed. In addition, the shown or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate. Parts displayed as units may or may not be physical units, and may be located in one position, or may be distributed on a plurality of network units. Some or all of the units may be selected according to actual needs to achieve the objects of the scheme of this embodiment.

In addition, functional units in the embodiments of the present disclosure may be integrated into one processing unit, or each of the units may exist alone physically, or two or more units may be integrated into one unit. The integrated unit may be implemented in a form of hardware, or may be implemented in a form of a software functional unit.

The integrated unit may be stored in a computer-readable storage medium if implemented in the form of a software functional unit and sold or used as an independent product. Based on such an understanding, the technical schemes of the present disclosure essentially, or the part contributing to the related art, or all or some of the technical schemes may be implemented in the form of a software product. The software product is stored in a storage medium, and includes several instructions for instructing a computer device (which may be a personal computer, a server, a network device, or the like) to execute all or some of the steps of the methods described in the embodiments of the present disclosure. The storage medium includes: any medium that can store program code, such as a USB flash drive, a removable hard disk, a read-only memory (ROM), a random access memory (RAM), a magnetic disk, or an optical disk.

Although some embodiments of the present disclosure are described above with reference to the accompanying drawings, these embodiments are not intended to limit the protection scope of the embodiments of the present disclosure. Any modifications, equivalent replacements and improvements made by those having ordinary skills in the art without departing from the scope and essence of the embodiments of the present disclosure shall fall within the protection scope of the embodiments of the present disclosure.

## Claims

1. A probe tip detection method, comprising:
acquiring a first image captured when electronic components are probed by a probe under detection, and extracting a probing image of a target electronic component from the first image;
aligning the probing image with a reference template, wherein the reference template is obtained by extracting the target electronic component in a second image, and the second image is captured when the target electronic component is not probed by the probe under detection;
establishing a grayscale matrix for the probing image and the reference template, and determining a tip shape of a tip of the probe under detection according to the grayscale matrix;
determining a plurality of tip perpendicular lines relative to an extension direction of the probe under detection from the first image, detecting the plurality of tip perpendicular lines line by line until a target grayscale point is detected, and determining a position of the target grayscale point as a tip position; and
obtaining a probe tip detection result based on the tip shape and the tip position.

2. The probe tip detection method of claim 1, wherein aligning the probing image with a reference template comprises:
selecting a first grayscale region from the reference template and establishing a first grayscale matrix corresponding to the first grayscale region;
selecting a second grayscale region from the probing image and establishing a second grayscale matrix corresponding to the second grayscale region, wherein at least two different grayscale values exist in the first grayscale region and the second grayscale region;
subtracting the second grayscale matrix from the first grayscale matrix to obtain an alignment matrix; and
adjusting the first grayscale region according to the alignment matrix until the reference template is aligned with the probing image.

3. The probe tip detection method of claim 2, wherein adjusting the first grayscale region according to the alignment matrix until the reference template is aligned with the probing image comprises:
summing an absolute value of each matrix element in the alignment matrix to obtain a matrix alignment value;
comparing the matrix alignment value with a preset alignment value to obtain a comparison result, wherein the preset alignment value is an alignment threshold indicating alignment of the first grayscale region and the second grayscale region;
in response to the comparison result indicating that the matrix alignment value is greater than the preset alignment value, determining a plurality of third grayscale regions from the reference template, and establishing a third grayscale matrix of each of the third grayscale regions;
subtracting the second grayscale matrix from each of the third grayscale matrices in sequence to obtain a plurality of new matrix alignment values; and
determining a target matrix alignment value from the plurality of new matrix alignment values, determining the third grayscale region corresponding to the target matrix alignment value as an alignment region with the second grayscale region, and aligning the reference template corresponding to the third grayscale region and the probing image corresponding to the second grayscale region based on the alignment region.

4. The probe tip detection method of claim 1, wherein the probing image and the reference template are of the same size; and establishing the grayscale matrix for the probing image and the reference template, and determining the tip shape of the tip of the probe under detection according to the grayscale matrix comprises:
establishing a binarized matrix based on a grayscale value of the reference template and establishing a fourth grayscale matrix based on a grayscale value of the probing image;
correspondingly multiplying matrix elements of the binarized matrix by matrix elements of the fourth grayscale matrix to obtain a tip morphology matrix; and
determining the tip shape of the probe under detection according to the tip morphology matrix.

5. The probe tip detection method of claim 4, wherein determining the tip shape of the probe under detection according to the tip morphology matrix comprises:
acquiring a tip grayscale threshold which is preset; and
binarizing matrix elements in the tip morphology matrix according to the tip grayscale threshold, and determining the tip shape of the probe under detection according to the binarized tip morphology matrix.

6. The probe tip detection method of claim 1, wherein determining the plurality of tip perpendicular lines relative to the extension direction of the probe under detection from the first image comprises:
selecting two detection points from each of the probes under detection in the first image, and calculating a directional slope of the probe under detection according to coordinates of the two detection points;
calculating a perpendicular slope of the tip based on the directional slope; and
determining the plurality of tip perpendicular lines along a direction of the perpendicular slope.

7. The probe tip detection method of claim 1, wherein after obtaining the probe tip detection result based on the tip shape and the tip position, the method further comprises:
issuing an alarm signal in response to the probe tip detection result indicating that the tip of the probe under detection is deformed; or
issuing an alarm signal in response to the probe tip detection result indicating that the tip of the probe under detection is outside a preset probing range, wherein the preset probing range is a range in which the tip of the probe under detection detects the target electronic component and is capable of obtaining a detection result.

8. A probe tip detection system, comprising:
a probing image acquisition module configured for acquiring a first image captured when electronic components are probed by a probe under detection, and extracting a probing image of a target electronic component from the first image;
an alignment module configured for aligning the probing image with a reference template, wherein the reference template is obtained by extracting the target electronic component in a second image, and the second image is captured when the target electronic component is not probed by the probe under detection;
a tip shape determination module configured for establishing a grayscale matrix for the probing image and the reference template, and determining a tip shape of a tip of the probe under detection according to the grayscale matrix;
a tip position determination module configured for determining a plurality of tip perpendicular lines relative to an extension direction of the probe under detection from the first image, detecting the plurality of tip perpendicular lines line by line until a target grayscale point is detected, and determining a position of the target grayscale point as a tip position; and
a probe tip detection result obtaining module configured for obtaining a probe tip detection result based on the tip shape and the tip position.

9. An electronic device, comprising a memory and a processor, wherein the memory has a computer program stored therein, and the computer program, when executed by the processor, causes the processor to perform the probe tip detection method of any one of claims 1 to 7.

10. A computer-readable storage medium, having a computer program stored therein, wherein the computer program, when executed by a processor, causes the processor to perform the probe tip detection method of any one of claims 1 to 7.
